**Europäisches Patentamt**

**European Patent Office**

**Office européen des brevets**

(11) Veröffentlichungsnummer: **0 162 148**

**A1**

(12) # EUROPÄISCHE PATENTANMELDUNG

(21) Anmeldenummer: **84115851.2**

(22) Anmeldetag: **19.12.84**

(51) Int. Cl.⁴: **G 01 R 31/28**
**G 06 F 15/18**

(30) Priorität: **19.04.84 DE 3414968**

(43) Veröffentlichungstag der Anmeldung:
**27.11.85 Patentblatt 85/48**

(84) Benannte Vertragsstaaten:
**AT CH DE FR GB IT LI NL SE**

(71) Anmelder: **Siemens Aktiengesellschaft**
**Berlin und München Wittelsbacherplatz 2**
**D-8000 München 2(DE)**

(72) Erfinder: **Kümmerlin, Lothar, Dipl.-Ing.**
**Schulstrasse 2**
**D-6729 Jockgrim(DE)**

(72) Erfinder: **Urban, Zdenek, Dipl.-Ing.**
**Linderhofstrasse 33**
**D-8000 München(DE)**

(54) **Verfahren zur Ermittlung der Zuordnung von Nadelkoordinaten eines Kontaktnadelfeldes zu den Adressen der Kontaktnadeln in einem Verdrahtungs-Prüfautomaten.**

(57) Ermittlung der Zuordnung von Nadelkoordinaten an einem Prüflingsadapter zu den Nadeladressen in einem Verdrahtungs- Prüfautomaten mittels über Zeilen, Spalten und Diagonalparallelen in einem Kontaktnadelfeld abbildende Strichmasken (SM1, SM2, SM3) durchgeführten Selbstlernläufen, mit denen die Verteilung der Nadeladressen auf Zeilen, Spalten und Diagonalparallelen festgestellt und abgespeichert wird, wobei die Reihenfolge der Zeilen und Spalten aus der erkennbaren Reihenfolge der Diagonalparallelen erschlossen bzw. durch zusätzliche Schaltmittel ($S_1$ ...$S_n$) bei den Selbstlernläufen über die Zeilen ($y_i$) und Spalten ($x_j$) abbildenden Strichmasken (SM4) erzwungen wird und eine Sortierung der Adressen nach Zeilen und Spalten die gesuchte Zuordnung liefert.

Die Erfindung wird angewandt bei Verdrahtungs-Prüfautomaten.

$y_i (x_j)$

SM4  $S_1$

A  $S_n$

FIG 5

Siemens Aktiengesellschaft     Unser Zeichen 0162148
Berlin und München            VPA 84 P 4420 !

Verfahren zur Ermittlung der Zuordnung von Nadelkoordinaten eines Kontaktnadelfeldes zu den Adressen der Kontaktnadeln in einem Verdrahtungs-Prüfautomaten

Die Erfindung bezieht sich auf ein Verfahren zur Ermittlung der unbekannten Zuordnung von Feldkoordinaten der Kontaktnadeln eines Kontaktnadelfeldes eines Prüflingsadapters zu den Adressen der Kontaktnadeln in einem Verdrahtungs-Prüfautomaten mit Selbstlernroutine für Adressen von Anschlußpunkten auf vorgegebenen Leitungszügen einer Leiterplatte.

Mit Verdrahtungs-Prüfautomaten können Leiterzüge auf Leiterplatten auf Durchgang und gegenseitige Isolation dadurch geprüft werden, daß die Leiterzüge an Anschlußpunkten mit Hilfe eines Kontaktnadelfeldes eines Prüflingsadapters kontaktiert und mit einem Verdrahtungs-Prüfautomaten verbunden werden. Zur Durchgangsprüfung wählt der Verdrahtungs-Prüfautomat die Adressen von Anschlußpunkte eines Leiterzuges kontaktierenden Kontaktnadeln an und stellt fest, ob von Anschlußpunkt zu Anschlußpunkt Durchgang vorhanden ist. Um festgestellte Fehler später besser auf den Prüflingen lokalisieren zu können, sollten zweckmäßigerweise die Fehler in x/y-Koordinaten bzw. Zeilen oder Spalten eines die Anschlußpunkte ebenso wie die Kontaktnadeln des Nadelfeldes festlegenden Rasters ausgedruckt werden. Bei einer vorgegebenen Verdrahtung des Nadelfeldes des Prüflingsadapters kann die Zuordnung der Nadeladressen zu den Koordinaten der Nadeln des Adapters aus der Verdrahtungsvorschrift des Nadelfeldes ermittelt werden. Oft müssen jedoch Verdrahtungen des Nadelfeldes nach örtlich vorliegenden verbindungstechnischen Gesichtspunkten erfolgen, so daß die von der Verdrahtung bestimmte

Li 4 Bz / 16.04.1984

Zuordnung der Adressen der Nadeln zu ihren Koordinaten im Nadelfeld unbekannt ist.

Der Erfindung lag die Aufgabe zugrunde, die Zuordnung der Nadelkoordinaten zu den Nadeladressen weitgehend mit Hilfe des Prüfautomaten selbst zu ermitteln. Dabei soll eine Eigenschaft von Verdrahtungs-Prüfautomaten ausgenutzt werden, die es den Automaten ermöglicht, die Adressen von Anschlußpunkten auf Leiterzügen in Selbstlernläufen des Automaten zu lernen.

Diese Aufgabe wird mit einem eingangs genannten Verfahren gelöst, das gemäß der Erfindung die kennzeichnenden Merkmale des Anspruchs 1 aufweist.

Ein abgewandeltes Verfahren zur Ermittlung der unbekannten Zuordnung von Koordinaten der Nadeln eines Kontaktnadelfeldes eines Prüflingsadapters zu den Adressen der Kontaktnadeln in einem Verdrahtungs-Prüfautomaten mit Selbstlernroutine für die Adressen von Anschlußpunkten auf vorgegebenen Leitungszügen einer Leiterplatte ist dadurch gekennzeichnet, daß Strichmasken mit die Zeilen bzw. Spalten eines dem Nadelfeld zugrunde liegenden Rasters nachbildenden Leiterzügen dem Nadelfeld des Adapters unterlegt und unter einer durch zusätzliche Schaltmittel erzwungenen Reihenfolge der Zeilen bzw. Spalten nachbildenden Leiterzügen in Selbstlernläufen des Verdrahtungs-Prüfautomaten die Verteilung der Nadeladressen auf Zeilen und Spalten festgestellt und abgespeichert wird, wobei eine Sortierung der Adressen nach zusätzlich gespeicherten Zeilen- und Spaltenindizes die gesuchte Zuordnung ergibt.

Verdrahtungs-Prüfautomaten sind so programmiert, daß sie auch bei den Selbstlernläufen von einer größten Adresse ausgehend Leitungszug um Leitungszug adressenmäßig abarbeiten. Deshalb liegen nach den Selbstlernläufen weder die über die Zeilen und Spalten verteilten Nadeladressen noch die Zeilen und Spalten ohne weiteres Dazutun in ihrer richtigen Reihenfolge auf den Strichmasken gespeichert vor. Hier helfen beim Verfahren nach Anspruch 1 die Selbstlernläufe über die Strichmasken mit diagonal-parallelen Leiterzügen, weil die Adressenlisten dieser Leiterzüge durch die unterschiedliche Anzahl der auf sie entfallenden Anschluß- oder Rasterpunkte leicht in die richtige Reihenfolge gebracht werden können.

Beim Verfahren nach Anspruch 2 wird eine bestimmte Reihenfolge der Zeilen und Spalten durch die zusätzlichen Schaltmittel erzwungen.

Eine Weiterbildung des Verfahrens nach Anspruch 1 ist zusätzlich dadurch gekennzeichnet, daß eine die Hälfte aller Diagonalparallelen einer Anstiegsrichtung nachbildende Strichmaske nach einem ersten Selbstlernlauf des Verdrahtungs-Prüfautomaten für einen zweiten Selbstlernlauf um 180° gedreht dem Adapter unterlegt wird. Durch diese Maßnahme kann eine zusätzliche Strichmaske für die zweite Hälfte der Diagonalparallelen eingespart werden.

Eine weitere Einsparung von Strichmasken wird dadurch ermöglicht, daß die Strichmaske mit den Zeilen nachbildenden Leiterzügen nach einem ersten Selbstlernlauf für einen zweiten Selbstlernlauf über den Spalten um 90° gedreht dem Adapter unterlegt wird.

Zweckmäßig bestehen die eine bestimmte Reihenfolge der Zeilen bzw. Spalten während eines Selbstlernlaufs erzwingenden Schaltmittel aus die Zeilen bzw. Spalten nachbildenden Leiterzüge der Strichmaske einzeln an einen von allen Leiterzügen isolierten Anschlußpunkt auf der Strichmaske anschließenden Schaltern.

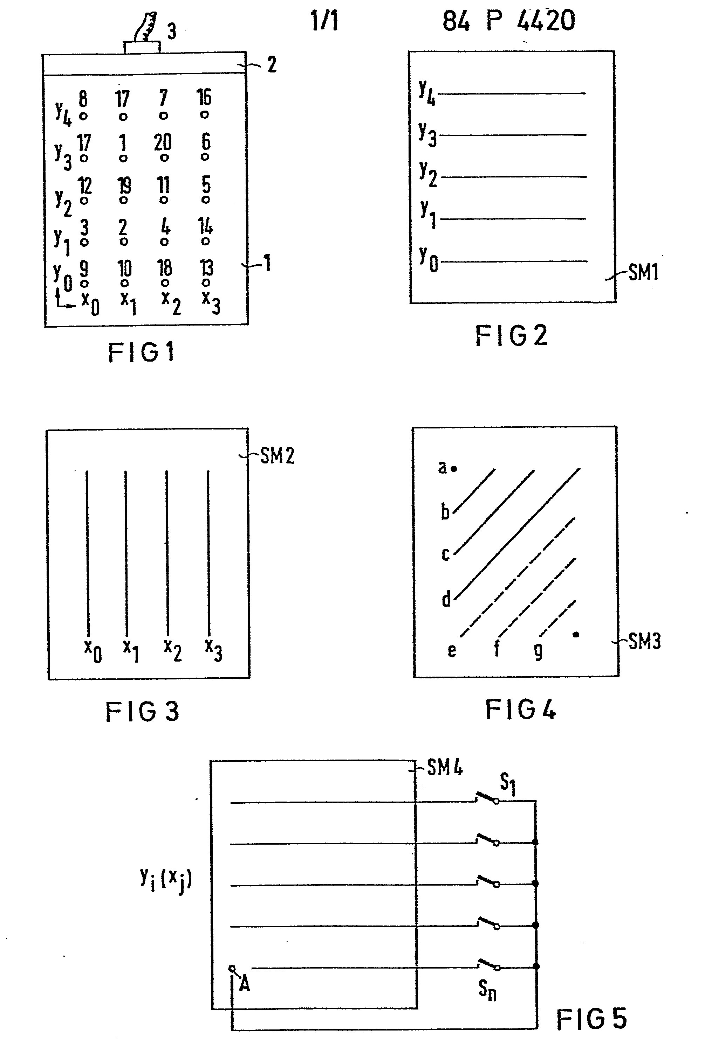

Die Erfindung wird anhand von fünf Figuren erläutert. Figur 1 stellt eine Adapterplatte mit einem Kontaktnadelfeld in einer Aufsicht dar.

Die Figuren 2, 3 und 4 zeigen Strichmasken, das sind Leiterplatten mit in Zeilen- bzw. Spaltenrichtung bzw. in diagonaler Richtung verlaufenden Leiterzügen.

In Figur 5 ist eine Strichmaske mit in der Aufsicht zeilenförmigen Leiterzügen mit zusätzlichen Schaltmitteln zur Identifikation der Reihenfolge der Zeilen dargestellt.

In Figur 1 ist eine Adapterplatte 1 zu erkennen, auf der ein Kontaktnadelfeld, das 4 x 5 Kontaktnadeln enthält, rasterförmig angeordnet ist. Das Rastermaß entspricht zweckmäßig einem genormten Rastermaß für die Schaltpunkte von geätzten Leiterplatten. Auf der Adapterplatte 1 befinden sich Leiterzuführungen zu jeder einzelnen Kontaktnadel des Kontaktnadelfeldes, die der Übersichtlichkeit wegen nicht eingezeichnet sind. Diese Verdrahtung mündet in einer Steckerleiste 2, von der ein Kabel 3 zu einem nicht dargestellten Verdrahtungs-Prüfautomaten führt. In einem Speicher dieses Automaten ist für jede Kontaktnadel eine Adresse verzeichnet. Weil die Verdrahtung des Nadelfeldes jedoch nach örtlich gegebenen verbindungstechnischen Gesichtspunkten erfolgt, ist die Zuordnung der Nadeladressen zu den Koordinaten der Nadeln im Nadelfeld, die am Rand der Adapterplatte 1 angezeigt sind, zunächst unbekannt. In der Figur 1 sind außer den Nadelkoordinaten $x_0 \ldots x_3$ und $y_0 \ldots y_4$ auch als angenommene Adressen der einzelnen Nadeln Zahlen 1 ... 20 eingetragen. Diese Adressen sind ihrer Zuordnung zu den Koordinaten nach infolge der unregelmäßigen Verdrahtung zunächst unbekannt und werden erst durch das vorliegende Verfahren den Nadelkoordinaten automatisch zuordenbar.

Figur 2 zeigt eine Strichmaske SM1 mit fünf zeilenförmigen Leiterzügen in Zeilenrichtung, die mit den Koordinaten $y_0 \ldots y_4$ benannt sind.

Figur 3 stellt eine Strichmaske SM2 mit vier Leiterzügen in Spaltenrichtung dar, die mit den Koordinaten $x_0 \ldots x_3$ bezeichnet sind.

Figur 4 ist eine Aufsicht auf eine Strichmaske SM3 mit drei diagonal-parallelen Leiterzügen und einem einzelnen Diagonalpunkt. Die mit b, c, d benannten Leiterzüge auf der Strichmaske SM3 der Figur 4 verlaufen in Richtung derjenigen Geraden, auf der Rasterpunkte mit den Koordinaten $x_0$, $y_1$; $x_1$, $y_2$; $x_2$, $y_3$ und $x_3$, $y_4$ liegen, bzw. in Richtung der beiden noch vorhandenen diagonal-parallele Rasterpunkte verbindenden Geraden links davon. Der linke obere Eckpunkt ist mit a benannt.

Die Rastermaße der Strichmasken SM1, SM2, SM3 stimmen mit den Rastermaßen der Adapterplatte überein.

Wird nun eine fünf Zeilen enthaltende Strichmaske SM1 nach Figur 2 unter die Adapterplatte nach Figur 1 gelegt und ein Selbstlernlauf des Verdrahtungs-Prüfautomaten eingeleitet, so sind die in der folgenden Tabelle aufgezeichneten Adressenangaben, die in einem Speicher des Automaten abgespeichert werden, zu erwarten. Dabei wird vorausgesetzt, daß der Verdrahtungs-Prüfautomat so programmiert ist, daß er bei jedem Lauf mit der höchsten Adresse anfängt:

| | | | | | |
|---|---|---|---|---|---|
| $(y_3)$ | 1 | 6 | 17 | 20 | |
| $(y_2)$ | 5 | 11 | 12 | 19 | |
| $(y_0)$ | 9 | 10 | 13 | 18 | |
| $(y_4)$ | 7 | 8 | 15 | 16 | |
| $(y_1)$ | 2 | 3 | 4 | 14 | Tabelle 1 |

Diese Adressentabelle wird aufgrund der in der Figur 1 angenommenen Adressenverteilung auf die Nadeln des Kontaktnadelfeldes entstehen. Die y-Koordinaten der Zeilen der Tabelle sind noch unbekannt. Dies ist durch eingeklammerte Zeilenkoordinaten angedeutet. Ebenso unbekannt ist natürlich auch die richtige Reihenfolge der Adressen innerhalb der einzelnen Zeilen.

Ein Selbstlernlauf über die Strichmaske SM2 nach Figur 3 mit den spaltenförmigen Leiterzügen führt zur folgenden Tabelle für die spaltenmäßige Adressenverteilung auf der Adapterplatte:

| 20 | 19 | 17 | 16 |
|----|----|----|----|
| 18 | 15 | 12 | 14 |
| 11 | 10 | 9 | 13 |
| 7 | 2 | 8 | 6 |
| 4 | 1 | 3 | 5 |
| $(x_2)$ | $(x_1)$ | $(x_0)$ | $(x_3)$ |

Tabelle 2

Auch die spaltenmäßigen Koordinaten $x_0$ ... $x_3$ der in den einzelnen Spalten der Tabelle 2 enthaltenen Adressen sind noch unbekannt; dies ist ebenfalls durch Klammern angedeutet.

Ein Selbstlernlauf über der Strichmaske SM3 nach Figur 4 ergibt die der Reihenfolge der Diagonalparallelen nach schon geordnete Tabelle:

| b | 15 | 17 |    |
|---|----|----|----|
| c | 1  | 7  | 12 |
| d | 3  | 16 | 19 | 20 |

Tabelle 3

Der Schlüssel für die Bestimmung der Koordinaten der Zeilen und Spalten und damit auch der einzelnen Adressen liegt in der unterschiedlichen Anzahl der mit der Strichmaske SM3 nach Figur 4 durch die diagonal-parallelen Leiterzüge erfaßten Rasterpunkte bzw. Kontaktnadeln. Die Tabelle 3 kann deshalb nach der Anzahl der festgestellten Nadeladressen für jeden Leiterzug in der richtigen Zeilenfolge angeordnet werden, wobei die Reihenfolge der Adressen innerhalb einer Zeile noch unbestimmt ist.

Die Reihenfolge der Adressen innerhalb der Zeilen der Tabelle 3 erschließt sich ausgehend vom mittleren Rasterpunkt der drei Rasterpunkte enthaltenden Diagonalparallelen c. Er ist aus der Zeilentabelle 1 und der Spaltentabelle 2 erkennbar, denn er muß dort mit den beiden
Rasterpunktadressen der Diagonalparallelen b jeweils gemeinsam in einer Zeile bzw. in einer Spalte vorkommen.
Die Adresse des mittleren Rasterpunktes der Diagonalparallelen muß also 1 sein. Nur diese Adresse kommt zusammen mit den Adressen 15 und 17 in einer Zeile $(y_3)$
und in einer Spalte $(x_1)$ vor. Für die Adressen 12 und 7
trifft dies nicht zu, sie stehen nur entweder in einer
Spalte oder in einer Zeile mit 17 bzw. 15 zusammen.

Mit einer spiegelbildlich zu Figur 4 angelegten Strichmaske kann in einem Selbstlernlauf eine Tabelle 4 erstellt
werden, aus der wieder der mittlere Rasterpunkt der drei
Rasterpunkte enthaltenden Diagonalparallelen - wie oben -
bestimmt werden kann:

| g | 14 | 18 | | | |
|---|----|----|---|---|---|
| f | 4 | 5 | 10 | | |
| e | 2 | 6 | 9 | 11 | Tabelle 4 |

Auf diese Weise lassen sich die richtige Reihenfolge der
Zeilen und Spalten nach den Tabellen 1 und 2 und damit
die koordinatenmäßige Zuordnung der Adressen feststellen.
Die logischen Abläufe zur richtigen gegenseitigen Zuordnung der Adressen und Koordinaten sind in einem Mikroprozessor des Verdrahtungs-Prüfautomaten einprogrammiert.

In der Figur 5 ist eine Strichmaske SM4 dargestellt, die
n waagrechte Leiterzüge aufweist. Die Abstände der Leiterzüge entsprechen dem Raster des Kontaktnadelfeldes des
Adapters. Die Länge der Leiterzüge muß mindestens der längeren Seite des Kontaktnadelfeldes entsprechen, wenn dieses rechteckig ist. Jedem Leiterzug ist auf der die Strichmaske SM4 tragenden Leiterplatte oder auch außerhalb davon
ein Schalter zugeordnet, dessen einer Kontakt mit dem Leiterzug verbunden ist. Die anderen Kontakte der Schalter

$S_1 \ldots S_n$ aller Leiterzüge sind parallelgeschaltet und mit einem separaten Anschlußpunkt A innerhalb der Strichmaske SM4 verbunden. Im Ausführungsbeispiel liegt der Anschlußpunkt A in der linken unteren Ecke der Strichmaske SM4.

Bei einem Selbstlernlauf wird mit Hilfe der Schalter, wie im folgenden weiter ausgeführt, eine bestimmte Reihenfolge der über den Selbstlernlauf festgestellten zeilen- und spaltenmäßigen Adressenverteilung erzwungen. Die Schalter $S_1 \ldots S_n$ werden dazu vom Prüfautomaten während der Selbstlernläufe entsprechend angesteuert.

Zur Ermittlung der Zuordnung der Adressen der einzelnen Kontaktnadeln zu den Koordinaten des Kontaktnadelfeldes wird die Strichmaske SM4 dem Adapter mit dem Kontaktnadelfeld unterlegt und der Adapter abgesenkt. Dann wird vom Prüfautomaten der Schalter $S_1$ angesteuert. Dadurch ist die erste Reihe der Strichmaske SM4 gegen den Anschlußpunkt A geschaltet. In einem ersten Prüflauf auf Durchgangsfehler werden alle Punkte der ersten Zeile ihren Adressen nach gelernt. In einem zweiten Lauf wird der Anschlußpunkt A mit Hilfe des Schalters $S_2$ gegen die zweite Zeile geschaltet und in einem Selbstlernlauf die Adressen der zweiten Zeile gelernt.

Schon aus dem ersten und zweiten Lauf kann softwaremäßig die Adresse des Anschlußpunktes A bestimmt werden, denn seine Adresse kommt im Gegensatz zu den anderen bei jedem der beiden Läufe vor.

Auch während des dritten bis n-ten Selbstlernlaufes werden die den entsprechenden Zeilen zugehörigen Schalter betätigt und jeweils diejenigen Adressen gespeichert, die zum Anschlußpunkt A eine Verbindung haben. Bei allen Selbstlernläufen werden neben den in einer Zeile vorkommenden Adressen auch die zugehörigen Zeilennummern mit abgespeichert.

Ist die zeilenmäßige Adressenverteilung ermittelt, wird die Strichmaske SM4 unter dem Adapter um 90° gedreht und der oben geschilderte Durchgang für m Spalten wiederholt.

Softwaremäßig werden nun nacheinander die für eine Zeile $y_i$ und eine Spalte $x_j$ gelernten und gespeicherten Adressen angewählt und nach einer beiden Adressenlisten gemeinsamen Adresse untersucht. Die Koordinaten dieser Adresse sind die der angewählten Zeile und Spalte. Dem Rasterpunkt bzw. der Kontaktnadel mit der ermittelten Adresse werden also aus der Kenntnis der beim Selbstlernen mit aufgezeichneten Zeilen- und Spaltennummern seine Koordinaten zugeordnet. Diese Zuordnung wird abgespeichert.

5 Patentansprüche
5 Figuren

Patentansprüche

1. Verfahren zur Ermittlung der unbekannten Zuordnung von Feldkoordinaten der Kontaktnadeln eines Kontaktnadelfeldes eines Prüflingsadapters zu den Adressen der Kontaktnadeln in einem Verdrahtungs-Prüfautomaten mit Selbstlernroutine für Adressen von Anschlußpunkten auf vorgegebenen Leitungszügen einer Leiterplatte, d a d u r c h   g e - k e n n z e i c h n e t , daß Strichmasken (SM1, SM2, SM3) mit die Zeilen ($y_0 \ldots y_4$) bzw. Spalten ($x_0 \ldots x_3$) bzw. jeweils eine Hälfte aller Diagonalparallelen (b, c, d einer Anstiegsrichtung eines dem Nadelfeld zugrunde liegen den Rasters nachbildenden Leiterzügen nacheinander dem Nadelfeld des Adapters (1) unterlegt und in Selbstlernläufen des Verdrahtungs-Prüfautomaten die Verteilung der Nadeladressen (1 ... 20) auf Zeilen ($y_0 \ldots y_4$), Spalten ($x_0 \ldots x_3$) und Diagonalparallelen (b, c, d) festgestellt und abgespeichert wird und die Reihenfolge der Zeilen ($y_0 \ldots y_4$) und Spalten ($x_0 \ldots x_3$) aus der durch die wachsende Anzahl ihrer Rasterpunkte gegebenen Reihenfolge der Diagonalparallelen (b, c, d) erschlossen wird, wobei eine Sortierung der Adressen (1 ... 20) nach Zeilen- und Spaltenindizes die gesuchte Zuordnung ergibt.

2. Verfahren zur Ermittlung der unbekannten Zuordnung von Koordinaten der Nadeln eines Kontaktnadelfeldes eines Prüflingsadapters zu den Adressen der Kontaktnadeln in einem Verdrahtungs-Prüfautomaten mit Selbstlernroutine für die Adressen von Anschlußpunkten auf vorgegebenen Leitungszügen einer Leiterplatte, d a d u r c h   g e - k e n n z e i c h n e t , daß Strichmasken (SM4) mit die Zeilen ($y_i$) bzw. Spalten ($x_j$) eines dem Nadelfeld zugrunde liegenden Rasters nachbildenden Leiterzügen dem Nadelfeld des Adapters (1) unterlegt und unter einer durch zusätz- liche Schaltmittel ($S_1 \ldots S_n$) erzwungenen Reihenfolge der Zeilen ($y_i$) bzw. Spalten ($x_j$) in Selbstlernläufen des Verdrahtungs-Prüfautomaten die Verteilung der Nadeladres-

sen auf Zeilen ($y_i$) und Spalten ($x_j$) festgestellt und abgespeichert wird, wobei eine Sortierung der Adressen nach zusätzlich gespeicherten Zeilen- und Spaltenindizes (i, j) die gesuchte Zuordnung ergibt.

3. Verfahren nach Anspruch 1, d a d u r c h   g e - k e n n z e i c h n e t ,  daß eine die Hälfte aller Diagonalparallelen (b, c, d) einer Anstiegsrichtung nachbildende Strichmaske (SM3) nach einem ersten Selbstlernlauf des Verdrahtungs-Prüfautomaten für einen zweiten Selbstlernlauf um 180° gedreht dem Adapter unterlegt wird.

4. Verfahren nach Anspruch 1 oder 2, d a d u r c h   g e k e n n z e i c h n e t ,  daß als Zeilen und Spalten nachbildende Leiterzüge eine einzige Strichmaske (SM1) vorgesehen ist, die nach einem ersten Selbstlernlauf für einen zweiten Selbstlernlauf um 90° gedreht dem Adapter (1) unterlegt wird.

5. Verfahren nach Anspruch 2, d a d u r c h   g e - k e n n z e i c h n e t ,  daß die eine bestimmte Reihenfolge der Zeilen ($y_i$) bzw. Spalten ($x_j$) während eines Selbstlernlaufes erzwingenden Schaltmittel aus die Zeilen ($y_i$) bzw. Spalten ($x_j$) nachbildenden Leiterzügen der Strichmaske (SM4) einzeln an einen von allen Leiterzügen isolierten Anschlußpunkt (A) auf der Strichmaske (SM4) anschließenden Schaltern ($S_1$ ... $S_n$) bestehen.

0162148

84 P 4420

3

2

$y_4$   8   17   7   16

$y_3$   17   1   20   6

$y_2$   12   19   11   5

$y_1$   3   2   4   14

$y_0$   9   10   18   13

$x_0$   $x_1$   $x_2$   $x_3$

1

FIG 1

$y_4$

$y_3$

$y_2$

$y_1$

$y_0$

SM1

FIG 2

SM2

$x_0$   $x_1$   $x_2$   $x_3$

FIG 3

a

b

c

d

e   f   g

SM3

FIG 4

SM4   $S_1$

$y_i(x_j)$

A

$S_n$

FIG 5

Europäisches
Patentamt

EUROPÄISCHER RECHERCHENBERICHT

0162148
Nummer der Anmeldung

EP   84 11 5851

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| Y | IBM TECHNICAL DISCLOSURE BULLETIN, Band 21, Nr. 3, August 1978; L.H. FAURE et al. "Reference location detector apparatus", Seiten 1019-1020 <br> * Seiten 1019-1020 * | 1 | G 01 R   31/28 <br> G 06 F   15/18 |
| | --- | | |
| Y | DE-A-2 219 149   (JENOPTIK) <br> * Ansprüche 1, 11 * | 1 | |
| | --- | | |
| A | FR-A-2 501 455   (SOCAPEX) <br> * Anspruch 1, Figuren 1, 2 * | 1 | |
| | --- | | |
| A | EP-A-0 078 339   (IBM) <br> * Ansprüche 9, 10 * | 1 | |
| | ----- | | RECHERCHIERTE SACHGEBIETE (Int. Cl.4) |
| | | | G 01 R   31/28 <br> G 06 F   15/18 |

Der vorliegende Recherchenbericht wurde für alle Patentansprüche erstellt.

| Recherchenort <br> BERLIN | Abschlußdatum der Recherche <br> 17-07-1985 | Prüfer <br> LEMMERICH J |
|---|---|---|